# DEMANDE DE BREVET EUROPEEN

(11) **EP 1 587 148 A1**
(43) Date de publication de la demande: **19.10.2005**
(21) Numéro de dépôt: 04358003.4
(22) Date de dépôt: 13.04.2004
(51) Int. Cl.: H01L 31/042, H02J 7/35

(54) **Module photovoltaique et ensemble photovoltaique de production d'energie électrique le mettant en oeuvre**

(71) Demandeur: Apex BP Solar, 34270 St Mathieu de Tréviers (FR)
(72) Inventeur: Rouvière, Benoit, 34321 St-Mathieu-de-Treviers (FR)
(74) Mandataire: De Kezel, Eric

(57) **Abrégé**

La présente invention concerne un module photovoltaïque sécurisé de transformation d'énergie solaire en énergie électrique, de préférence en courant électrique continu, comprenant au moins un assemblage d'au moins une cellule photovoltaïque, deux bornes de sortie dites de puissance (sécurisées) sur lesquelles est connecté directement ou indirectement un accumulateur d'électricité (de préférence au moins une batterie de stockage de l'énergie électrique ainsi produite), et un système antivol qui connecte l'assemblage de cellules photovoltaïques aux deux bornes de sortie.

## Description

L'invention concerne un module photovoltaïque destiné à transformer l'énergie solaire en un courant électrique continu.
Elle concerne également un ensemble photovoltaïque (champ photovoltaïque) mettant en oeuvre un ou plusieurs modules photovoltaïques destinés à transformer l'énergie solaire en un courant électrique continu selon la présente invention. Cet ensemble comprend également au moins un accumulateur d'électricité, de préférence une ou plusieurs batteries de stockage d'électricité et éventuellement un convertisseur de puissance DC-DC permettant d'adapter la tension de la batterie à la tension du champ photovoltaïque.

De tels ensembles de production et de stockage d'énergie électrique sont particulièrement adaptés dans des lieux isolés c'est-à-dire là où la distribution d'énergie électrique par voie traditionnelle, c'est à dire par réseau s'avère d'un coût prohibitif. Ces ensembles peuvent cependant être également utilisé pour tout autre utilisation des champs photovoltaïques (connecté au réseau).

Malheureusement, les panneaux solaires mis en oeuvre dans ces ensembles sont fréquemment subtilisés ou volés, afin d'être revendus ou montés en d'autres lieux. Afin de s'opposer à ces actes malveillants, on a proposé pour les décourager, d'axer la protection sous l'angle mécanique, notamment par le biais de structures mécano-soudées, réalisées notamment en acier inoxydable, constituant ainsi un ensemble inviolable. Outre le fait, que de tels ensembles sont lourds et nécessitent généralement d'être réalisés en usine, ils affectent également la modularité des installations de production d'énergie électrique mettant en oeuvre ces modules photovoltaïques. On a également proposé de mettre en oeuvre des visseries inviolables faisant appel à des têtes de vis complexes, nécessitant pour leur mise en place comme pour leur retrait des clés spéciales. Dans un cas comme dans l'autre, de telles protections mécaniques s'avèrent ne constituer que de simples retardateurs, leur fonction dissuasive n'étant néanmoins pas suffisante pour faire échec de manière satisfaisante à ces vols.

On a alors proposé des dispositifs électriques ou électroniques, et notamment des systèmes d'alarme, constitués par exemple d'une boucle électrique passant par l'ensemble des modules photovoltaïques mis en oeuvre au sein d'une installation, et qui lorsqu'elle est ouverte, déclenche un signal d'alarme, radio, téléphonique ou visuel ou une combinaison de ces signaux, voir avertit une centrale de gardiennage. On conçoit volontiers que compte-tenu du lieu d'implantation de ces installations, de tels systèmes d'alarme s'avèrent en général inopérants et en tout cas peu dissuasifs.

On a également proposé de mettre en place un repérage ou marquage spécifique au niveau des modules. Ce marquage peut se présenter sous la forme d'une couche indélébile colorée, visible de loin et identifiable au propriétaire de l'installation ou à la compagnie assurant la maintenance et la location de tels modules, ou encore, sous la forme d'un marquage proprement dit. Si certes, ce repérage décourage les éventuels fraudeurs soucieux de procéder à ces vols en vue de la revente des modules, affectant de fait leur intérêt marchand, en revanche, il n'empêche pas une utilisation pour son propre usage.

Enfin, on a également proposé d'intégrer au sein des modules un micro-émetteur, alimenté par l'énergie électrique produite par le module lui-même, et destiné à émettre selon une couverture déterminée, typiquement un rayon d'un kilomètre par rapport au module, un signal susceptible d'être perçu par un récepteur et identifiant ledit module.

Certes, ce signal permet de repérer le module. Cependant, celui-ci reste opérationnel, de sorte que ce système s'avère faiblement dissuasif. Par ailleurs, un tel système s'avère relativement coûteux.

L'objet de l'invention est donc de proposer un module photovoltaïque, destiné à décourager le vol ou même le simple emprunt en rendant le module non fonctionnel.

Ce module photovoltaïque, destiné à transformer l'énergie solaire en courant électrique continu, comprend deux bornes de sortie dites de puissance, sur lesquelles est connecté directement ou indirectement au moins un accumulateur d'électricité.
Ainsi, la présente invention concerne un module photovoltaïque sécurisé de transformation d'énergie solaire en énergie électrique, de préférence en courant électrique continu, comprenant
a. au moins un assemblage d'au moins une cellule photovoltaïque,
b. deux bornes de sortie dites de puissance (sécurisées) sur lesquelles est connecté directement ou indirectement un accumulateur d'électricité (de préférence au moins une batterie de stockage de l'énergie électrique ainsi produite), et
c. un système antivol qui connecte l'assemblage de cellules photovoltaïques aux deux bornes de sortie,
caractérisé en ce que le système antivol
comprend un interrupteur capable de neutraliser la puissance disponible en sortie aux deux bornes de puissance, et
est alimenté en permanence par le courant électrique provenant soit de l'assemblage d'au moins une cellule photovoltaïque, soit de l'accumulateur d'électricité.

Selon un mode préféré de la présente invention, tant que l'alimentation du système antivol n'est pas interrompue, à savoir tant que le système antivol est alimenté soit par la cellule photovoltaïque, soit par l'accumulateur d'électricité, l'interrupteur est dit être en état opérationnel, c'est-à-dire rendant le module opérationnel.

Selon un mode préféré de la présente invention, dès que l'alimentation du système antivol est interrompue, à savoir lorsque le système antivol n'est plus alimenté ni par la cellule photovoltaïque, ni par l'accumulateur d'électricité, l'interrupteur est dit être en état non opérationnel, c'est-à-dire rendant le module non opérationnel.
En fait, on entend par état non opérationnel, le fait que l'interrupteur coupe ou met en court circuit les bornes de sortie du module, et ainsi neutralise l'alimentation de l'énergie électrique fournie par le module ; ceci rend le dit module non fonctionnel, affectant de manière rédhibitoire sa valeur marchande, et réduit à néant toute utilisation éventuelle d'un acquéreur peu scrupuleux.

Selon un mode préféré de la présente invention, l'interrupteur est en état non opérationnel avant sa mise en service. Ceci représente un avantage supplémentaire de la présente invention car cela permet d'éviter que des personnes fassent une utilisation frauduleuses des dits panneaux avant leur mise en service.

Ainsi, selon un mode préféré de la présente invention, l'interrupteur est mis en état opérationnel lors de la mise en service du module, ce qui s'effectue après que le module a été connecté à l'accumulateur d'électricité.

Cette mise en état opérationnel de l'interrupteur peut être effectuée par tout moyen approprié. On citera à titre d'exemple un périphérique au protocole « 1 wire » (clef électronique « iButton »), un dispositif mécanique (clef), un dispositif sans contact (i-tag, myfar, ...) un, un dispositif de type wifi ou blue tooth, un clavier à code, etc ...

Selon un mode préféré de la présente invention, l'interrupteur est noyé dans de la résine à l'arrière de la face active du module, c'est à dire de la face exposée au rayonnement solaire ou est encapsulé dans la structure sandwich constitutive du module lui-même, de telle sorte que toute tentative d'extraction de l'interrupteur hors du module revient à le rendre définitivement inutilisable.

Cet interrupteur est avantageusement un interrupteur électronique du type transistor à effet de champ réalisé selon la technologie MOS-FET, mais peut également être constitué d'un relais électromécanique ou tout autre dispositif aboutissant au même résultat.

Le module photovoltaïque conforme à la présente invention peut également intégrer en plus de l'interrupteur un ensemble de traitement, par exemple un circuit électronique qui enregistre des paramètres de fonctionnement de l'installation au sein de laquelle est mise en place ledit module.
L'invention concerne également un ensemble photovoltaïque comprenant le module photovoltaïque conforme à la présente invention (deux bornes de sortie de puissance, au moins un assemblage d'au moins une cellule photovoltaïque et le système antivol) et un accumulateur d'électricité (comprenant au moins une ou plusieurs batteries de stockage de l'électricité ainsi produite) relié aux deux bornes de sortie de puissance du module photovoltaïque. Un convertisseur de puissance DC-DC permettant d'adapter la tension de la batterie à la tension du champ photovoltaïque peut également être intégré au système.
Selon un mode préféré, l'ensemble photovoltaïque conforme à la présente invention est caractérisé en ce que la liaison entre l'accumulateur d'électricité et les bornes de sortie de puissance du module photovoltaïque ne comprend pas de dispositif ayant une fonction anti-retour du courant provenant de la batterie, par exemple une diode anti-retour.
Les figures qui suivent sont décrites au travers de modes de réalisation de la présente invention qui sont données à titre indicatif et non limitatif.

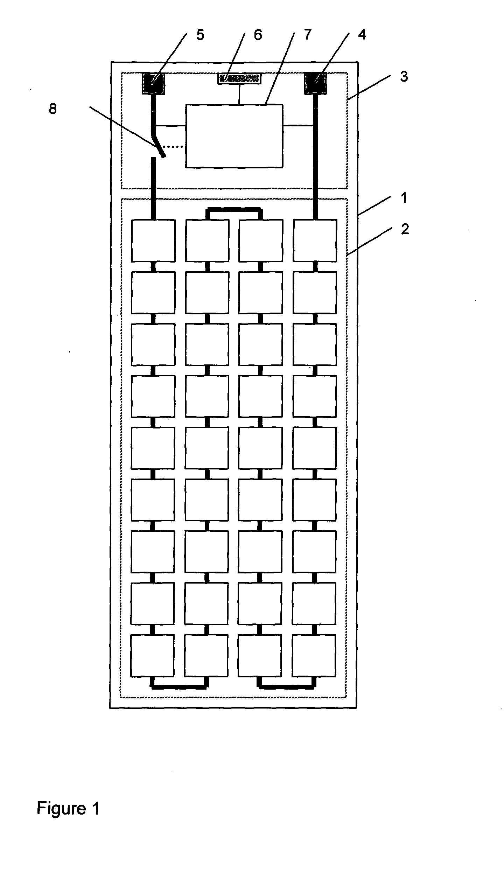

La figure 1 est une représentation schématique d'un module photovoltaïque conforme à l'invention.

Dans la figure 1, on distingue le module photovoltaïque (1) qui est d'un type en soi connu pour la transformation du rayonnement solaire en courant électrique continu. Ce module comporte l'assemblage d'au moins une cellule photovoltaïque (2), comprend les deux bornes de puissance (4) et (5), et le un système antivol (3) qui connecte l'assemblage de cellules photovoltaïques aux deux bornes de sortie. Le système antivol comprend dans la figure 1, l'interrupteur (8), dans le cas d'espèce un transistor à effet de champ réalisé selon la technologie MOS FET (mais peut aussi être un relais électromécanique), le dispositif de mise en service (6) et l'électronique de commande (7).

Selon une particularité de l'invention, le système antivol (3) est intégré dans le module (1) et est coulé dans une résine solidarisée au module à l'arrière des panneaux solaires, de telle sorte à rendre l'accès impossible à l'interrupteur sans aboutir à la destruction de la face active dudit module, et partant sans rendre totalement inutilisable celui-ci.

Dans le montage décrit au sein de la figure 1, l'interrupteur est monté en série. On peut néanmoins concevoir que l'interrupteur soit monté en parallèle, mettant alors en court-circuit les deux bornes de puissances (4) et (5) du module.

Le fonctionnement préféré de l'électronique de commande (7) est :
- de maintenir l'interrupteur en état non opérationnel lors de sa mise sous tension et ce tant que la mise en service du module sécurisé n'a pas été effectuée,
- de maintenir l'interrupteur en état opérationnel, après sa mise en service, tant que le système d'antivol est alimenté (par la batterie ou l'assemblage d'au moins une cellule photovoltaïque) et ce jusqu'à l'arrêt de l'alimentation.

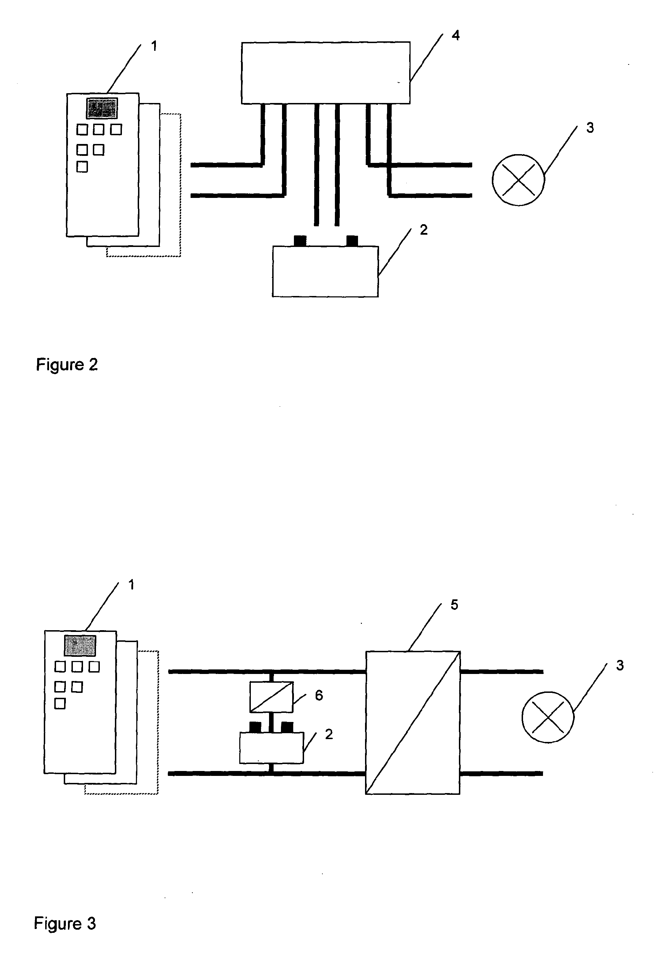

La figure 2 est une représentation schématique d'un ensemble photovoltaïque conforme à l'invention. Cette installation comprend un ou plusieurs modules photovoltaïques (champ photovoltaïque) de production d'énergie électrique (1), ledit module étant relié par un organe de régulation (4), à une batterie (2), destinée à stocker l'énergie électrique ainsi produite. Cette énergie est utilisée par une charge (3) soit directement en courant continu soit en courant alternatif (dans ce cas un onduleur est placé entre l'organe de régulation et la charge) transforme le courant continu stocké dans la batterie en courant alternatif.
Le principe de fonctionnement du système de sécurisation reposant sur la continuité d'alimentation du système antivol, il est impératif que l'organe de régulation (4) ne comporte pas de dispositif d'anti-retour dont le rôle est d'empêcher la décharge de la batterie dans la module photovoltaïque la nuit. Avec un dispositif d'anti-ietour (diode ou transistor a effet de champ), la batterie serait alors déconnectée la nuit du module, donc le système d'antivol plus alimenté, entraînant de fait la mise de l'interrupteur est en état non opérationnel, c'est-à-dire rendant le module non opérationnel et ce jusqu'à la prochaine mise en service.
La figure 3 est une autre représentation schématique d'un ensemble photovoltaïque conforme à l'invention. Cette installation comprend un ou plusieurs modules photovoltaïques (champ photovoltaïque) de production d'énergie électrique (1), ledit module étant relié par un organe de conversion d'énergie (5), à une charge (3). Cette charge peut être un pompe dans le cas de « pompage au fil du soleil » ou le réseau dans le cas de « générateur photovoltaïque raccordé au réseau ». Dans ces applications, la batterie (2) est connecté au champ photovoltaïque par un convertisseur DC/DC (6) permettant d'adapter la tension de sortie de la batterie à la tension de sortie du champ photovoltaïque. Ce convertisseur est bidirectionnel, c'est à dire permettant la charge de la batterie la journée et alimentant la nuit le système antivol. Ainsi il n'y a aucune rupture d'alimentation du système antivol sauf si le module photovoltaïque est déconnecté de la batterie et/ou du DC/DC.

## Revendications

1. Module photovoltaïque sécurisé de transformation d'énergie solaire en énergie électrique, de préférence en courant électrique continu, comprenant
a. au moins un assemblage d'au moins une cellule photovoltaïque,
b. deux bornes de sortie dites de puissance (sécurisées) sur lesquelles est connecté directement ou indirectement un accumulateur d'électricité, et
c. un système antivol qui connecte l'assemblage de cellules photovoltaïques aux deux bornes de sortie,
**caractérisé en ce que** le système antivol
comprend un interrupteur capable de neutraliser la puissance disponible en sortie aux deux bornes de puissance, et
est alimenté en permanence par le courant électrique provenant soit de l'assemblage d'au moins une cellule photovoltaïque, soit de l'accumulateur d'électricité.

2. Module selon la revendication 1 **caractérisé en ce que** l'interrupteur est maintenu en état opérationnel, c'est-à-dire rendant le module opérationnel, tant que l'alimentation du système antivol n'est pas interrompue.

3. Module selon l'une quelconque des revendications précédentes **caractérisé en ce que** l'interrupteur est en état non opérationnel, c'est-à-dire rendant le module non opérationnel, dès que l'alimentation du système antivol est interrompue.

4. Module selon l'une quelconque des revendications précédentes **caractérisé en ce que** l'interrupteur est en état non opérationnel avant sa mise en service.

5. Module selon l'une quelconque des revendications précédentes **caractérisé en ce que** l'interrupteur est mis en état opérationnel lors de la mise en service du module.

6. Module selon la revendication précédente **caractérisé en ce que** la mise en service est effectuée après que le module ait été connecté à l'accumulateur d'électricité.

7. Module selon l'une quelconque des revendications précédentes **caractérisé en ce que** l'interrupteur est mis en état opérationnel par tout type de moyen incluant une un périphérique au protocole « 1 wire » (clef électronique « iButton »), un dispositif mécanique (clef), un dispositif sans contact (i-tag, myfar, ...) un, un dispositif de type wifi ou blue tooth, un clavier à code, etc ...

8. Ensemble photovoltaïque comprenant le module photovoltaïque selon l'une quelconque des revendications précédentes et un accumulateur d'électricité relié aux deux bornes de sortie de puissance du module photovoltaïque.

9. Ensemble photovoltaïque selon la revendication précédente, **caractérisé en ce que** la liaison entre l'accumulateur d'électricité et les bornes de sortie de puissance du module photovoltaïque ne comprennent pas de dispositif ayant une fonction anti-retour du courant provenant de la batterie.
